# EUROPÄISCHE PATENTSCHRIFT

(11) **EP 1 791 255 B1**
(45) Veröffentlichungstag und Bekanntmachung des Hinweises auf die Patenterteilung: **27.04.2011**
(21) Anmeldenummer: 06021419.4
(22) Anmeldetag: 12.10.2006
(51) Int. Cl.: H03J 7/18, G08C 17/02

(54) **Funkübertragungssystem**
Radio communication system
Système de radiocommunication

(30) Priorität: 29.11.2005 DE 102005056933
(43) Veröffentlichungstag der Anmeldung: 30.05.2007
(73) Patentinhaber: Prof. Dr. Horst Ziegler und Partner GbR, 33100 Paderborn (DE)
(72) Erfinder: Ziegler, Horst, Prof. Dr., 33100 Paderborn (DE)
(74) Vertreter: Tiesmeyer, Johannes

(56) Entgegenhaltungen:
- WO-A-98/37528
- WO-A-98/59427
- DE-A1- 10 346 900
- US-A1- 5 822 373

## Beschreibung

Die Erfindung betrifft ein Funkübertragungssystem mit wenigstens einem Funksender, der eine Sendesteuerschaltung aufweist und dazu eingerichtet ist, nach einem bestimmten Sendezeitschema Funktelegramme mit einem jeweiligen Nutzdatenteil und einem dem Nutzdatenteil vorausgehenden Headerteil, der eine bestimmte Modulationsstruktur aufweist, zu senden, und mit wenigstens einem eine Empfangssteuerschaltung enthaltenden Funkempfänger zum Empfang von Funktelegrammen von dem Funksender, wobei der Funkempfänger dazu eingerichtet ist, in einer von der Empfangssteuerschaltung gesteuerten Suchlauf-Betriebsart einen automatischen Funkempfangsfrequenz-Suchlauf durchzuführen, um die Funkempfangsfrequenz des Funkempfängers auf die Funksendefrequenz des Funksenders abzustimmen, wobei der Funkempfänger bei dem Funkempfangsfrequenz-Suchlauf einen gegebenen Frequenztoleranzbereich zyklisch auf Empfang eines Funksignals mit einer Modulationsstruktur entsprechend der des Headerteils von Funktelegrammen des Funksenders absucht.

Funkübertragungssysteme der hier betrachteten Art kommen z.B. im Gebäudeverwaltungsbereich zum Einsatz, etwa bei der Verbrauchsdatenerfassung betreffend den Heizmittelverbrauch, Wasserverbrauch, Gasverbrauch oder Stromverbrauch in einer Wohnung oder sonstigen Gebäudenutzungseinheit. Derartige Funkübertragungssysteme und damit ausgestattete Verbrauchsdaten-Erfassungssysteme sind z.B. aus der DE 103 46 900 A1 bekannt. Zum Stand der Technik wird ferner auf die EP 1 028 403 A2, die EP 1 037 185 A2 oder die EP 1 392 078 A2 verwiesen. Bei solchen Verbrauchsdaten-Erfassungssystemen sind in den betreffenden Nutzungseinheiten eines Gebäudes vorgesehene Verbrauchszähler mit Funksendern ausgestattet, die Zählerstandsdaten und Kennungsinformationen zur Verbrauchszähleridentifizierung zu bestimmten bzw. pseudostochastisch eingerichteten Sendezeitintervallen senden. Diesen Funksenderendgeräten sind Funkempfänger zugeordnet, welche die Funktelegramme empfangen und daraus abgeleitete Daten ggf. über weitere Stationen an eine Abrechnungszentrale senden. Bei den Funksenderendgeräten handelt es sich häufig um batteriebetriebene Geräte mit unidirektionalem Funkbetrieb und somit ohne Funkempfangsfunktion. Der Stromverbrauch der Verbrauchsmessgeräte und ihrer Funksender sollte möglichst gering sein, damit Langzeitbatterien als elektrische Energiequellen verwendet werden können und somit nur seltener Batterieaustauschbedarf bei den Geräten vorliegt.

Die Funksender der hier betrachteten Art sind vorzugsweise für einen entsprechenden Energie sparenden Betrieb ausgelegt, was sich darin äußert, dass sie nicht im Dauerbetrieb senden, sondern Funktelegramme nach einem Sendezeitschema in Zeitintervallen mit dazwischen liegenden Pausen senden. Im Falle eines Verbrauchsmessgerätes kann es ausreichen, wenn der Funksender die Funktelegramme mit den Verbrauchsmessdaten und Kennungsinformationen nur gelegentlich in kleinen Sendezeitfenstern überträgt, so dass sich die Phasen erhöhten Strombedarfs des Verbrauchsmessgerätes auf diese Sendezeitfenster im Wesentlichen beschränken.

In diesem Zusammenhang kann zum Stand der Technik auf die EP 1 028 403 A2 verwiesen werden, aus der ein Funkübertragungssystem der hier betrachteten Art als Bestandteil eines Verbrauchsdaten-Erfassungssystems bekannt ist. Bei dem Datenübertragungssystem nach der EP 1 028 403 A2 wird bei gegebener Zuordnung zwischen einem jeweiligen Funksender eines Endgerätes (z.B. Wärmemengenzählers) und einem Funkempfänger von der Möglichkeit der verbesserten Abschätzung des Zeitpunktes der nächsten Datensendung vom Sender zum Empfänger Gebrauch gemacht. Um ein zu einem bestimmten Zeitpunkt erwartetes Datenpaket von einem Sender mit großer Wahrscheinlichkeit empfangen zu können, ist es erforderlich, den Empfänger während eines Toleranzzeitintervalls (Empfangsbereitschafts-Zeitintervall) um den vermuteten Zeitpunkt herum empfangsbereit zu halten. Trifft das Funktelegramm in diesem Empfangsbereitschafts-Zeitintervall ein, so kann die Zeitzählung empfängerseitig auf den Eintreffzeitpunkt des Datenpakets neu bezogen werden und somit relativ zum Sender resynchronisiert werden. Auf diese Weise kann eine durchlaufende Akkumulation des Zeitfehlers verhindert werden.

Bei dem Datenübertragungssystem nach der EP 1 028 403 A2 weist der jeweilige Funkempfänger eine Empfangssteuerschaltung zur zeitlichen Steuerung seines Empfangsbetriebs auf, die auf der Basis von Sollwerten für die Zeitabstände aufeinander folgender Funktelegrammsendungen des betreffenden Senders den jeweiligen Zeitpunkt der erwarteten nächsten Datensendung abschätzt, d.h. kalkuliert, und den Empfänger zeitweilig jeweils in einem Empfangsbereitschafts-Zeitintervall, das den geschätzten Zeitpunkt enthält, empfangsbereit schaltet. Diese Empfangsbereitschafts-Zeitintervalle des Funkempfängers sollten möglichst kurz sein, um den Funkkanal möglichst selten zu besetzen und ferner den elektrischen Energiebedarf des Funkempfängers niedrig zu halten. Auch der Funkempfänger kann ein batteriebetriebenes Gerät sein.

Das Sendezeitschema kann beinhalten, dass die Funksender zu ihnen zugeordneten festen Zeiten, z.B. periodisch ihre Funktelegramme senden, wobei die Sendezeiten dem betreffenden Funkempfänger bekannt sind. Die Sendezeiten können in einem elektronischen Speicher des Funkempfängers abgelegt sein oder ggf. nach einem bestimmten Algorithmus jeweils berechnet werden. Das Sendezeitschema kann auch beinhalten, dass die Sendezeiten pseudostochastisch nach einem für den betreffenden Funksender und den Funkempfänger verbindlichen Algorithmus jeweils bestimmt werden. Derartige Sendezeitschemen sind dem Fachmann bekannt, so dass sich detailliertere Erläuterungen hierzu erübrigen.

Weiterhin offenbart die US 5 822 373 A1 ein Funkübertragungssystem der eingangs genannten Art. Die übertragenen Funktelegramme bestehen dabei aus einem Headerteil und einem Nutzdatenteil, wobei der Headerteil mit einer geringeren, zum Beispiel halb so großen, Datenrate übertragen wird wie der Nutzdatenteil und die Modulationsstruktur der Funktelegramme so eingestellt wird, dass das übertragene Signal maximal während der Hälfte der Übertragungszeit auf "Ein" ist. Der Empfänger verfügt über einstellbare Filter jeweils vor und nach dem Demodulationsteil. Während eines Empfangsfrequenz-Suchlaufs wird der Filter vor der Demodulation bei hoher Bandbreite betrieben, um das Vorhandensein eines Empfangssignals sicher detektieren zu können, und der Filter nach der Demodulation wird mit niedriger Bandbreite betrieben, um den mit niedriger Datenrate übertragenen Headerteil weiter zu verarbeiten und Rauschen zu unterdrücken. Sobald ein Headerteil erkannt wurde, schaltet sich der Empfänger auf das empfangene Signal auf und der Filter vor der Demodulation wird auf niedrige Bandbreite umgeschaltet, um andere Signale als das Empfangssignal abzuweisen, und der Filter nach dem Demodulaüonsteil wird auf hohe Bandbreite gesetzt, um den mit hoher Datenrate gesendeten Nutzdatenteil weiterverarbeiten zu können. Auf diese Weise soll es ermöglicht werden, einen preiswerten Sender zu verwenden und die Übertragungszeit gering zu halten, wobei der Empfänger dennoch empfindlich sein kann.

Insbesondere für stationäre Funkübertragungssysteme ist die Reichweite der Funkverbindung zwischen Funksendern und einem den Sendern zugeordneten Funkempfänger insbesondere auch von großer wirtschaftlicher Bedeutung. Die Anzahl an Funksendern, von denen ein Funkempfänger Funktelegrammsendungen sicher empfangen kann (Ausstattungsfaktor), hängt nämlich wesentlich von der Reichweite ab. Im Falle eines Verbrauchsdaten-Erfassungssystems wird bei hoher Funkreichweite des darin einbezogenen Funkübertragungssystems in vielen Fällen ein Funkempfänger je Liegenschaft oder je Treppenhaus genügen, wohingegen bei geringer Funkreichweite meist in jedem Stockwerk ein solcher Treppenhaus-Funkempfänger vorhanden sein muss, um die Funktelegrammsendungen aller mit Funksendern ausgestatteten Verbrauchsmessgeräte in dem betreffenden Gebäude erfassen zu können. Da ein solcher Primär-Funkempfänger erheblich teurer ist als ein mit Funksender ausgestattetes Endgerät, spielen seine auch auf die ihm zugeordneten Endgeräte umgelegten Kosten für Fertigung, Montage und Inbetriebnahme eine Rolle bei der Beurteilung der Wirtschaftlichkeit eines Verbrauchsdaten-Erfassungssystems mit Funkfernablesung. Eine Steigerung der Sendeleistung der Funksender wäre eine Möglichkeit der Reichweitenvergrößerung. Diese Möglichkeit ist jedoch bei den Endgeräten durch die Zulassungsgrenzen des Frequenzbandes, durch die Kosten für die aufwendigeren Sendekomponenten und auch durch die Leistungsfähigkeit und Größe der Batterie bzw. des Pufferkondensators begrenzt. Eine weitere Einflusskomponente für die Funkreichweite ist die Empfindlichkeit des Funkempfängers, die hauptsächlich durch die nutzbare Empfängerbandbreite bestimmt wird. Die Empfängerbandbreite kann bei heutigen Empfängerbausteinen in weiten Bereichen entweder durch Wahl eines geeigneten ZF-Filters oder bei digitalen ZF-Filtern sogar dynamisch frei gewählt werden. Die für eine hohe Empfangsempfindlichkeit und damit für eine funktechnisch hohe Reichweite erforderliche minimale Empfangsbandbreite erfordert üblicherweise eine langsame Modulation zur Erzielung einer kleinen Senderbandbreite. Langsame Modulation bedeutet aber, dass auch die Funktelegramme länger dauern, was wiederum unerwünscht ist, da dies einen zeitlich verlängerten Sende- und Empfangsbetrieb für die Datenübermittlung zwischen einem Sender und einem Empfänger bedeutet und somit eine größere Belastung der Stromversorgungsbatterien mit sich bringt. Bei den üblicherweise verwendeten hohen Funkfrequenzen (meist 868 MHz - 870 MHz) spielen die Frequenztoleranzen der Taktgeberquarze der Sender und Empfänger die dominante Rolle bei der Wahl der nutzbaren Empfängerbandbreite und somit bei der erreichbaren Empfangsempfindlichkeit und der Funkreichweite der betreffenden Funkverbindungen.

Aus Kostengründen werden in den Endgeräten mit Funksendern als Taktgeber für die Trägerfrequenz nur Quarze mit relativ großer Fertigungstoleranz und vergleichsweise starker Temperaturabhängigkeit der Schwingungsfrequenz eingesetzt. Bei den in geringerer Stückzahl erforderlichen Funkempfängern werden üblicherweise hochwertigere Schwingquarze als Taktgeber verwertet, deren Fertigungstoleranz und deren Abhängigkeit der Frequenz von der Temperatur relativ gering sind. Die für eine Funkverbindung zwischen Sender und Empfänger erforderliche effektive Empfängerbandbreite hängt somit dominant von der Frequenzgenauigkeit, also von Fertigungstoleranzen, Alterung und Temperatureinfluss des Senderquarzes ab. Zu große Abweichungen der vom Senderquarz bestimmten Sendefrequenz (Trägerfrequenz) von einer am Empfänger eingestellten Soll-Empfangsfrequenz kann dazu führen, dass die Sendefrequenz außerhalb der Empfangsbandbreite des Empfängers liegt, so dass Funktelegrammsendungen des Senders von dem Empfänger nicht empfangen werden.

Bei Verbrauchsmessgeräten, die hohen Temperaturen ausgesetzt sind, etwa Heizkostenverteilern, Wärmemengenzählern o.dgl., kommt erschwerend hinzu, dass der die Sendefrequenz bestimmende Senderquarz stark schwankenden und teilweise hohen Temperaturen ausgesetzt ist, so dass seine Temperaturabhängigkeit der Frequenz eine viel größere Rolle spielt als die Temperaturabhängigkeit der Frequenz bei dem normalerweise nur den Raumtemperaturschwankungen ausgesetzten Quarzen des Empfängers. Bisher wurde die Empfängerbandbreite aus der Summe der Toleranzen der Frequenzen des Senderquarzes und des Empfängerquarzes zuzüglich der erforlichen Signalbandbreite bestimmt. Auf diese Weise ergibt sich eine relativ große Empfängerbandbreite und eine vergleichsweise geringe Empfangsempfindlichkeit mit der Folge, dass auch die Funkreichweite nicht sehr groß ist.

Etwas kleinere effektive Empfängerbandbreiten ließen sich realisieren, wenn ein Fertigungsabgleich der Senderquarze und Empfängerquarze vorgenommen würde. Ein solcher Fertigungsabgleich ist aber aufwendig und teuer und berücksichtigt nicht zeitliche Änderungen der Quarzfrequenz durch Alterung und Temperatureinflüsse. Klassische AFC-Frequenzregelungen wie beim Rundfunkempfang scheiden bei Funkübertragungssystemen der hier betrachteten Art aus, da die Funksender hier nur sehr kurze Funktelegramme in relativ großen Zeitabständen senden. Es wäre wünschenswert, auch bei solchen Sendestrukturen trotz der großen Frequenztoleranzen der in den Sendern verwendeten preiswerten Quarze mit einer möglichst kleinen und im Idealfall mit einer im Wesentlichen durch die Sendebandbreite des Nutzsignals bestimmten Empfängerbandbreite auszukommen.

Der Erfindung liegt die Aufgabe zugrunde, ein Funkübertragungssystem der eingangs genannten Art bereitzustellen, welches trotz vergleichsweise geringer Frequenzstabilität des Funksenders mit einer vergleichsweise kleinen Empfängerbandbreite betrieben werden kann und somit eine größere Funkreichweite erlaubt.

Zur Lösung dieser Aufgabe wird bei einem Funkübertragungssystem der eingangs genannten Art vorgeschlagen, dass die Dauer des Headerteils der Funktelegramme länger ist als die Dauer eines Funkempfangsfrequenz-Suchlaufzyklus, so dass stets sichergestellt ist, dass das betreffende Funksignal während eines Suchlaufzyklus erkannt werden kann.

Der bei dem Funkempfangsfrequenz-Suchlauf durchgescannte Frequenztoleranzbereich ist vorzugsweise auf der Basis der Summe der möglichen Frequenzabweichungen der vom Funksender verwendeten Sendefrequenz (Trägerfrequenz) und der vom Funkempfänger verwendeten korrespondierenden Funkempfangsfrequenz vom Sollwert bestimmt worden, so dass die aufgrund der Frequenzungenauigkeiten der Taktgeber des Funksenders und des Funkempfängers zu berücksichtigenden Toleranzen den Suchlauf-Frequenztoleranzbereich bestimmen.

Der Suchlauf kann mit einer Suchbandbreite des Empfängers z.B. beim größten Frequenzwert des Frequenztoleranzbereichs gestartet und dann kontinuierlich oder ggf. zeit- und frequenzdiskret mit Verminderung der Suchfrequenz (also der Mittenfrequenz des Suchbandes) bis hin zum kleinsten Frequenzwert des Frequenztoleranzbereichs fortgesetzt werden. Dies geschieht unter Kontrolle der Empfangssteuerschaltung. Alternativ könnte der Suchlauf auch von dem niedrigsten Frequenzwert ausgehen und dann in Richtung zum höchsten Frequenzwert des Frequenztoleranzbereichs fortgesetzt werden. Denkbar wäre auch, dass sich die Suchrichtung beim Durchlaufen des Frequenztoleranzbereichs in aufeinander folgenden Suchzyklen ändert.

Es kommen alternativ weitere Suchstrategien bei dem Funkempfangsfrequenz-Suchlauf in Frage. So kann es vorgesehen sein, dass der Funkempfänger aus Informationen im Zusammenhang mit einem vorausgegangenen Funktelegramm eines Funksenders, von dem das nächste Funktelegramm erwartet wird, eine Empfangsfrequenz kalkulieren kann, bei welcher mit relativ großer Wahrscheinlichkeit das erwartete nächste Funktelegramm dieses Senders empfangen werden kann. Der Funkempfangsfrequenz-Suchlauf wird dann vorzugsweise mit einer solchen Empfangsfrequenzeinstellung mit maximaler Empfangswahrscheinlichkeit gestartet, wonach dann etwaige Nachbar-Suchfrequenzbänder als Suchziel gewählt werden. Eine solche Suchstrategie erlaubt normalerweise ein schnelleres Auffinden der für den Funkempfang korrekten Empfangsfrequenzeinstellung. In diesem Sinne kann die Empfangssteuerschaltung des Funkempfängers dazu eingerichtet sein, bei einem Funkempfangsfrequenz-Suchlaufzyklus für den Empfang eines erwarteten Funktelegramms eines Funksenders zunächst die Empfangsfrequenzeinstellungen zu wählen, bei welchen ein vorausgegangenes Funktelegramm dieses Funksenders empfangen wurde.

Weiterhin kann die Empfangssteuerschaltung des Funkempfängers dazu eingerichtet sein, den Funkempfangsfrequenz-Suchlauf spontan zu unterbrechen, sobald ein Funksignal mit einer Modulationsstruktur entsprechend der des Headerteils von Funktelegrammen eines betreffenden Funksenders empfangen worden ist. Der Nutzdatenteil des Funktelegramms wird dann mit der Empfangsfrequenz empfangen, bei der der Suchlauf unterbrochen wurde.

Alternativ kann es vorgesehen sein, dass bei jedem Suchzyklus der Frequenztoleranzbereich komplett durchlaufen wird, und zwar auch dann, wenn ein Funksignal mit zutreffendem Header registriert wird, wobei in diesem Fall die Empfangssteuerschaltung für den Empfang des Nutzdatenteils eines jeweiligen Funktelegramms die Empfangsfrequenz wählt, bei der die Empfangssteuerschaltung die maximale Empfangsfeldstärke bei der Detektion des Headers im Funkempfangsfrequenz-Suchlaufzyklus erfasst hat. Die Empfangssteuerschaltung ist hierzu mit Mitteln zur Erfassung der Empfangsfeldstärke bei Funksignalempfang ausgestattet. Viele auch für die Funkempfänger der vorliegenden Erfindung nutzbare Empfängerbausteine bieten die Ausgabe einer zum Logarithmus der momentanen Empfangsfeldstärke näherungsweise proportionalen Spannung (RSSI-Ausgangssignal) an. Dieses RSSI-Signal kann somit als Indikator für die Empfangsfeldstärke ausgewertet und in Beziehung zum jeweils eingestellten Suchfrequenzwert gesetzt werden, um den Frequenzwert maximaler Empfangsfeldstärke bei Funkempfang im Suchzyklus zu bestimmen. Dies erfolgt vorzugsweise mittels eines Mikroprozessors der Empfangssteuerschaltung des Funkempfängers.

Die Suchbandbreite beim Funkempfangsfrequenz-Suchlauf kann der normalen Empfangsbandbreite bei Empfang der Nutzdaten eines Funktelegramms entsprechen, sie wird jedoch stets erheblich kleiner als der Frequenztoleranzbereich sein, der beim Suchlauf zyklisch durchlaufen wird. Denkbar sind auch Suchlaufstrategien, bei welchen sich die Suchlaufbandbreite im Suchlaufzyklus ändert. Gemäß einer Ausführungsform der Erfindung ist die Empfangssteuerschaltung des Funkempfängers dazu eingerichtet, den Funkempfangsfrequenz-Suchlauf mit einer Suchbandbreite durchzuführen, die sich von der Funkempfangsbandbreite für den Nutzdatenempfang unterscheidet, insbesondere größer ist als die Funkempfangsbandbreite für den Nutzdatenempfang.

Vorzugsweise hat der Headerteil der Funktelegramme des Funksenders eine Modulationsstruktur mit einer 0-1-0-1-.....Binärdatenfolge. Registriert der Funkempfänger beim Suchlauf ein Funksignal mit dieser Binärdatenfolge, so interpretiert er dies als Suchtreffer.

Es könnte im Rahmen der Erfindung vorgesehen sein, dass der Funkempfänger stets in Empfangsbereitschaft ist und außerhalb der Nutzdatenempfangszeiten ständig im Suchlaufbetrieb ist. Bei einer bevorzugten Ausführungsform des Funkübertragungssystems nach der Erfindung ist der Funksender jedoch dazu eingerichtet, seine Funktelegramme nach Maßgabe des Sendezeitschemas während kurzer Sendezeitintervalle in Zeitabständen zu senden, wobei die Empfangssteuerschaltung des Funkempfängers dazu eingerichtet ist, nach Maßgabe des Sendezeitschemas den Funkempfänger für die Dauer jeweiliger Empfangsbereitschaftszeitintervalle empfangsbereit zu schalten, um Funktelegramme des Funksenders zu empfangen. Ein solches Zeitmanagement von Funkübertragungssystemen ist aus dem eingangs genannten Stand der Technik bereits bekannt. Bei einem erfindungsgemäß weiterentwickelten Funkübertragungssystem dieser Art wird der jeweilige Funkempfangsfrequenz-Suchlauf zu Beginn jedes Empfangsbereitschaftszeitintervalls gestartet. Die Empfangssteuerschaltung kann dazu eingerichtet sein, die Suchlaufstartfrequenz und den maximalen Suchlauffrequenzbereich für den jeweils nächsten Funkempfangsfrequenz-Suchlauf in Abhängigkeit von dem Zeitabstand vom letzten erfolgreichen Empfang eines Funktelegramms bis zum erwarteten Empfang des nächsten Funktelegramms von dem betreffenden Funksender festzulegen. Dabei wird vorausgesetzt, dass sich die Senderfrequenz bei relativ kurzzeitig aufeinander folgenden Funktelegrammen nicht so stark verändert haben wird, als es bei größeren Zeitabständen zwischen aufeinander folgenden Funktelegrammen des Funksenders der Fall sein könnte. Der in einem Suchlaufzyklus zu durchlaufende Frequenztoleranzbereich wird daher im letzteren Fall größer sein als im Fall kurzzeitig aufeinander folgender Funktelegramme.

Vorzugsweise ist der Funksender Element eines Messgerätes, wobei er dazu eingerichtet ist, Messdaten des Messgerätes in Funktelegrammen an den Funkempfänger zu senden.

Das Messgerät ist vorzugsweise ein Verbrauchsmessgerät, insbesondere elektronischer Heizkostenverteiler, Wasserzähler, Gaszähler, Wärmemengenzähler oder Stromzähler. Das Funksystem nach der Erfindung kann in dieser Weise in ein Verbrauchsdatenerfassungssystem integriert sein.

Vorzugsweise ist das Funkübertragungssystem nach der Erfindung für unidirektionalen Funkbetrieb für digitale Datenübertragung vom jeweiligen Funksender zum Funkempfänger ausgebildet. Es können somit preiswerte Funksender zum Einsatz kommen, welche keine eigenen Empfangsbausteine benötigen.

Die Erfindung wird nachstehend anhand der Figuren näher erläutert.
- Fig. 1: zeigt schematisch ein Funkübertragungssystem nach der Erfindung.
- Fig. 2: zeigt ein Zeitdiagramm zur Erläuterung des Funkbetriebs des Funkübertragungssystems nach Fig. 1.
- Fig. 3a - 3d: zeigen Zustands-Zeitdiagramme zur Erläuterung des Empfangsfrequenz-Suchlaufbetriebs des Funkempfängers.

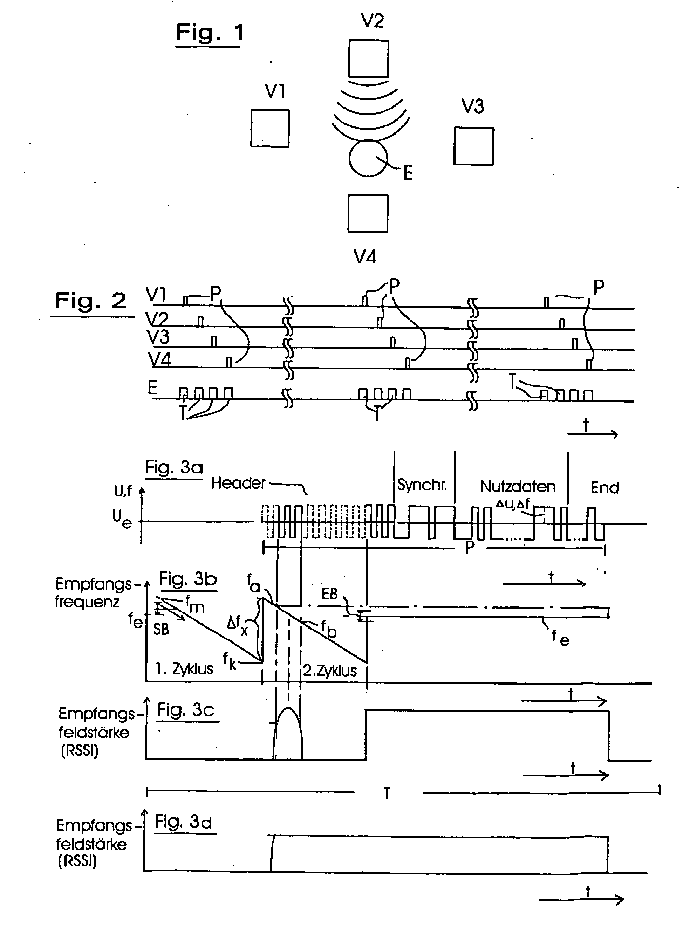

Fig. 1 zeigt schemtisch ein Funkübertragungssystem, welches in ein Verbrauchserfassungssystem mit Verbrauchsmessgeräten V1 - V4 integriert ist, wobei die Verbrauchsmessgeräte V1 - V4 in der Lage sind, ihren Zählerstand und ihre Zählernummer (Identifikationsinformation) per Funk zu einem Empfänger E unidirektional zu übertragen. Bei den Verbrauchsmessgeräten V1 - V4 kann es sich z.B. um Heizkostenverteiler in verschiedenen Wohnungen eines Hauses handeln, wobei der Empfänger E z.B. im gemeinsamen Treppenhaus vorgesehen ist, so dass die im Empfänger E gespeicherten Informationen über die Zählerstände der Verbrauchsmessgeräte V1 - V4 ggf. von einer autorisierten Person ausgelesen werden können, ohne dass diese Person die Wohnungen zu betreten hat, in denen die Verbrauchsmessgeräte V1 - V4 installiert sind. Denkbar ist auch, dass der Empfänger seine Informationen drahtgebunden oder z.B. über ein Mobilfunksystem an eine Zentrale weitersendet.

Die Geräte V1 - V4 senden ihre Funktelegramme zu bestimmten jedoch unterschiedlichen Zeiten zum Empfänger E.

In Fig. 2 sind in einem Zeitdiagramm die Sendezeitintervalle der Verbrauchsmessgeräte V1 - V4 schematisch durch Rechteckimpulse P angedeutet. Der Empfänger E enthält eine möglichst genau gehende Uhr, verfügt über Informationen über die Sendezeiten der Geräte V1 - V4 und ist so gesteuert, dass er die ebenfalls in Fig. 2 angedeuteten Zeitfenster T für den Funkempfang öffnet, wobei diese Zeitfenster T so bemessen sind, dass sie mit einem jeweiligen Sendeereignis P der Verbrauchszähler V1 - V4 zeitlich zusammenfallen.

Aus Toleranzgründen sind die Zeitfenster T jedoch größer als die Sendezeitfenster P. Zwischen aufeinander folgenden Funktelegrammen eines Gerätes V1 - V4 kann eine lange Pause von mehreren Stunden Dauer liegen.

In Fig. 3a ist in einem U-t-Diagramm ein Beispiel eines Signalverlaufs am Ausgang eines Demodulators des Funkempfängers E bei Empfang eines Funktelegramms schematisch dargestellt, wobei vorausgesetzt ist, dass ein anfänglicher Empfangsfrequenz-Suchlauf gemäß Fig. 3b und Fig. 3c stattfindet. Die nur gestrichelt eingezeichneten Header-Signalabschnitte sind in betreffenden Suchlaufabschnitten von Fig. 3b unterdrückt. Hierzu sei angemerkt, dass der Demodulator einen Diskriminator umfasst und zur Demodulierung von z.B. FSK-modulierten Empfangssignalen eingerichtet ist. An seinem Ausgang stellt der Demodulator ein Spannungssignal bereit, welches die Abweichung Δf der momentan empfangenen Frequenz von der Trägerfrequenz fₑ repräsentiert. Das Signal in Fig. 3a ist ein Rechtecksignal, welches die Signalzustände fₑ + Δf und fₑ- Δf repräsentiert, wobei fₑ die ursprüngliche Trägerfrequenz und Δf den benutzten Frequenzmodulationshub bezeichnen. Diese Binärzustände des Signals entsprechen den Bit-Werten 0/1 des Funktelegramms. Die Bitsequenz des Funktelegramms beginnt mit einem Header, dem ein Synchronisationsteil und ein Nutzdatenteil folgt, wie es in Fig. 3a angedeutet ist. Der Header ist protokollgemäß eine 0-1-0-1....Sequenz bekannter Länge, welcher zur Einstellung von Empfangsparametern genutzt werden kann.

Alternativ könnten für den Header auch andere markante Bitfolgen (Modulationsstrukturen) verwendet werden. Der Synchronisationsteil dient als Marke für den Beginn des Nutzdatenteils des Funktelegramms. In der Sequenz des Nutzdatenteils sind die eigentlichen Informationen codiert, welche Gegenstand der Informationsübertragung sind, also etwa Verbrauchsmesswerte und Verbrauchszählerkennungsinformationen.

Es sei angenommen, dass Fig. 3a ein Empfangsereignis des Empfängers E aus Fig. 1 in einem Empfangszeitfenster T gemäß Fig. 2 repräsentiert. Der Empfänger E empfängt daher ein Funktelegramm eines der Endgeräte V1...V4.

Da die Trägerfrequenz des betreffenden Senders z.B. aufgrund von Temperatureffekten des Sender-Taktgeberquarzes eine Änderung erfahren haben kann, besteht die Möglichkeit, dass die zuletzt für den Empfang eines Funktelegramms von dem betreffenden Sender gewählten Empfangseinstellung des Empfängers E nicht mehr passt und das erwartete Funktelegramm nicht sicher empfangen wird.

Fig. 3b zeigt ein Beispiel für einen Suchlaufbetrieb des Funkempfängers. Zu Beginn des betreffenden Empfangsbereitschaftszeitintervalls T startet die Empfangssteuerschaltung des Empfängers E den Suchlauf, indem sie die Empfangsfrequenz auf einen Maximalwert fₘ setzt. Daraufhin vermindert sie die Empfangsfrequenz kontinuierlich, bis der Minimalfrequenzwert fₖ erreicht ist. Damit ist dann der erste Suchzyklus über den Frequenztoleranzbereich Δfₓ abgeschlossen, wobei im Beispielsfall der Fig. 3b in diesem ersten Zyklus noch kein Funkempfang eines Signals mit der erwarteten Headerstruktur registriert worden ist. Das Durchscannen des Frequenztoleranzbereichs Δfₓ erfolgt mit der Suchbandbreite SB, die in etwa der Signalbandbreite entsprechen sollte. Im Beispielsfall ist angenommen worden, dass der Funkempfänger E das Funksignal im zweiten Suchzyklus registriert, und zwar ab der Frequenz fₐ und bis zur Frequenz f_{b} in Fig. 3b. Fig. 3c zeigt für dieses Beispiel das zeitliche Verhalten der Empfangsfeldstärke. Die Empfangssteuerschaltung des Empfängers E registriert den Verlauf der Empfangsfeldstärke in Abhängigkeit von der Suchfrequenz und wählt für den Empfang der Nutzdaten des Funksignals die Frequenz fₑ, bei der die Empfangsfeldstärke ihr Maximum in dem letzten Suchzyklus hatte. Dies ist in den Fig. 3b und 3c dargestellt. Während des Nutzdatenempfangs ist daher die Empfangsfeldstärke gemäß Fig. 3c entsprechend hoch. Gemäß Fig. 3b erfolgt die Einstellung auf die Empfangsfrequenz fₑ mit einer bestimmten Empfangsbandbreite EB unmittelbar nach Ablauf des Suchzyklus, in dem der Signalempfang registriert wurde. Denkbar ist auch eine Betriebsweise, bei der die Einstellung auf fₑ alsbald erfolgt, nachdem die Empfangssteuerschaltung festgestellt hat, dass das Maximum der Empfangsfeldstärke in dem Suchlaufzyklus erreicht worden ist.

Die Empfangsbandbreite EB sollte vorzugsweise nur unwesentlich größer sein als die theoretische Signalbandbreite. Die Suchbandbreite SB und die Empfangsbandbreite EB können z.B. gleich groß sein.

In Fig. 3d ist für eine alternative Suchbetriebsweise der Fall angedeutet, dass der Suchzyklus abgebrochen wurde, sobald das Funksignal mit dem typischen Header registriert worden ist. Der Funkempfang erfolgt dann mit der Einstellfrequenz fₐ als Mittenfrequenz des Empfangsbandes EB.

## Patentansprüche

1. Funkübertragungssystem mit wenigstens einem Funksender, der eine Sendesteuerschaltung aufweist und dazu eingerichtet ist, nach einem bestimmten Sendezeitschema Funktelegramme mit einem jeweiligen Nutzdatenteil und einem dem Nutzdatenteil vorausgehenden Headerteil, der eine bestimmte Modulationsstruktur aufweist, zu senden, und mit wenigstens einem eine Empfangssteuerschaltung enthaltenden Funkempfänger zum Empfang von Funktelegrammen von dem Funksender, wobei der Funkempfänger dazu eingerichtet ist, in einer von der Empfangssteuerschaltung gesteuerten Suchlauf-Betriebsart einen automatischen Funkempfangsfrequenz-Suchlauf durchzuführen, um die Funkempfangsfrequenz des Funkempfängers auf die Funksendefrequenz des Funksenders abzustimmen, wobei der Funkempfänger bei dem Funkempfangsfrequenz-Suchlauf einen gegebenen Frequenztoleranzbereich zyklisch auf Empfang eines Funksignals mit einer Modulationsstruktur entsprechend der des Headerteils von Funktelegrammen des Funksenders absucht, **dadurch gekennzeichnet, dass** die Dauer des Headerteils der Funktelegramme länger ist als die Dauer eines Funkempfangsfrequenz-Suchlaufzyklus.

2. Funkübertragungssystem nach Anspruch 1, **dadurch gekennzeichnet, dass** die Empfangssteuerschaltung des Funkempfängers Mittel zur Erfassung der Empfangsfeldstärke bei Funksignalempfang aufweist und dazu eingerichtet ist, für den Empfang des Nutzdatenteils eines jeweiligen Funktelegramms die Empfangsfrequenz zu wählen, bei der die Empfangssteuerschaltung die maximale Empfangsfeldstärke bei der Detektion des Headers im Funkempfangsfrequenz- Suchlaufzyklus erfasst hat.

3. Funkübertragungssystem nach Anspruch 1, **dadurch gekennzeichnet, dass** die Funktelegramme frequenzmodulierte Funksignale oder phasenmodulierte Funksignale sind.

4. Funkübertragungssystem nach Anspruch 1 oder 2, **dadurch gekennzeichnet, dass** der Headerteil der Funktelegramme des Funksenders eine Modulationsstruktur mit 0-1-0-1-...Binärdatenfolge enthält.

5. Funkübertragungssystem nach einem der vorhergehenden Ansprüche, **dadurch gekennzeichnet, dass** die Empfangssteuerschaltung des Funkempfängers dazu eingerichtet ist, bei einem Funkempfangsfrequenz-Suchlaufzyklus die Empfangsfrequenzeinstellungen nacheinander entsprechend abnehmender Wahrscheinlichkeit eines Empfangs eines Funktelegramms von einem betreffenden Sender vorzunehmen.

6. Funkübertragungssystem nach einem der vorhergehenden Ansprüche, **dadurch gekennzeichnet, dass** die Empfangssteuerschaltung des Funkempfängers dazu eingerichtet ist, bei einem Funkempfangsfrequenz-Suchlaufzyklus für den Empfang eines erwarteten Funktelegramms eines Funksenders zunächst die Empfangsfrequenzeinstellungen zu wählen, bei welcher ein vorausgegangenes Funktelegramm dieses Funksenders empfangen wurde.

7. Funkübertragungssystem nach einem der vorhergehenden Ansprüche, **dadurch gekennzeichnet, dass** der Funksender dazu eingerichtet ist, seine Funktelegramme nach Maßgabe des Sendezeitschemas während kurzer Sendezeitintervalle in Zeitabständen zu senden, und dass die Empfangssteuerschaltung des Funkempfängers dazu eingerichtet ist, nach Maßgabe des Sendezeitschemas den Funkempfänger für die Dauer jeweiliger Empfangsbereitschaftszeitintervalle empfangsbereit zu schalten, um Funktelegramme des Funksenders zu empfangen, wobei der jeweilige Funkempfangsfrequenz-Suchlauf zu Beginn jedes Empfangsbereitschaftszeitintervalls gestartet wird.

8. Funkübertragungssystem nach einem der vorhergehenden Ansprüche, **dadurch gekennzeichnet, dass** die Empfangssteuerschaltung des Funkempfängers dazu eingerichtet ist, den Funkempfangsfrequenz-Suchlauf mit einer Suchbandbreite durchzuführen, die sich von der Funkempfangsbandbreite für den Nutzdatenempfang unterscheidet, insbesondere größer ist als die Funkempfangsbandbreite für den Nutzdatenempfang.

9. Funkübertragungssystem nach einem der vorhergehenden Ansprüche, **dadurch gekennzeichnet, dass** die Empfangssteuerschaltung dazu eingerichtet ist, den automatischen Funkempfangsfrequenz-Suchlauf mit kontinuierlicher Abnahme der Funkempfangssuchfrequenz in jedem Suchzyklus durchzuführen.

10. Funkübertragungssystem nach einem der vorhergehenden Ansprüche, **dadurch gekennzeichnet, dass** die Empfangssteuerschaltung dazu eingerichtet ist, die Suchlaufstartfrequenz und den maximalen Suchlauffrequenzbereich für den jeweils nächsten Funkempfangsfrequenz-Suchlauf in Abhängigkeit von dem Zeitabstand vom letzten erfolgreichen Empfang eines Funktelegramms bis zum erwarteten Empfang des nächsten Funktelegramms von dem betreffenden Sender festzulegen.

11. Funkübertragungssystem nach einem der vorhergehenden Ansprüche, **dadurch gekennzeichnet, dass** der Funksender Element eines Messgerätes ist, wobei er dazu eingerichtet ist, Messdaten des Messgerätes in Funktelegrammen an den Funkempfänger zu senden.

12. Funksystem nach Anspruch 11, **dadurch gekennzeichnet, dass** das Messgerät ein Verbrauchsmessgerät, insbesondere elektronischer Heizkostenverteiler, Wasserzähler, Gaszähler, Wärmemengenzähler oder Stromzähler ist.

13. Funkübertragungssystem nach einem der vorhergehenden Ansprüche, **dadurch gekennzeichnet, dass** es für unidirektionalen Funkbetrieb für digitale Datenübertragung vom jeweiligen Funksender zum Funkempfänger ausgebildet ist.

## Claims

1. A radio transmission system with a radio transmitter which has a transmitting control circuit and is set up to send, in accordance with a specific transmitting time scheme, radio messages with a respective useful data portion and a header portion which precedes the useful data portion and has a specific modulation structure, and with at least one radio receiver including the receiving control circuit for receiving radio message from the radio transmitter, wherein the radio receiver is set up to carry out in a search operation mode controlled by the receiving control circuit an automatic radio receiving frequency search operation so as to match the radio receiving frequency of the radio receiver to the radio transmitting frequency, wherein in the radio receiving frequency search operation the radio receiver scans a given frequency tolerance range cyclically for reception of a radio signal with a modulation structure corresponding to that of the header portion of radio messages of the radio transmitter, **characterised in that** the duration of the header portion of the radio messages is longer than the duration of a radio receiving frequency search operation cycle.

2. A radio transmission system according to Claim 1, **characterised in that** the receiving control circuit of the radio receiver has means for detecting the receiving field strength upon radio signal reception and is set up to select, for the reception of the useful data portion of a respective radio message, the receiving frequency at which the receiving control circuit has detected the maximum receiving field strength upon detection of the header in the radio receiving frequency search operation cycle.

3. A radio transmission system according to Claim 1, **characterised in that** the radio messages are frequency-modulated radio signals or phase-modulated radio signals.

4. A radio transmission system according to Claim 1 or 2, **characterised in that** the header portion of the radio messages of the radio transmitter contains a modulation structure with 0-1-0-1-... binary data sequence.

5. A radio transmission system according to any one of the preceding Claims, **characterised in that** the receiving control circuit of the radio receiver is set up, in a radio receiving frequency search operation cycle, to carry out the receiving frequency settings with successively correspondingly decreasing probabilities of reception of a radio message from a relevant transmitter.

6. A radio transmission system according to any one of the preceding Claims, **characterised in that** the receiving control circuit of the radio receiver is set up, in a radio receiving frequency search operation cycle, to select for the reception of an expected radio message of a radio transmitter initially the receiving frequency settings at which a preceding radio message of this radio transmitter has been received.

7. A radio transmission system according to any one of the preceding Claims, **characterised in that** the radio transmitter is set up to transmit in time intervals its radio messages according to the transmitting time scheme during short transmitting time intervals, and **in that** the receiving control circuit of the radio receiver is set up, according to the transmitting time scheme, to switch the radio receiver ready to receive for the duration of respective receiving-readiness time intervals so as to receive radio messages of the radio transmitter, wherein the respective radio receiving frequency search operation is started at the beginning of each receiving-readiness time interval.

8. A radio transmission system according to any one of the preceding Claims, **characterised in that** the receiving control circuit of the radio receiver is set up to carry out the radio receiving frequency search operation at a search band width which differs from the radio receiving band width for the useful data reception, in particular is greater than the radio receiving band width for the useful data reception.

9. A radio transmission system according to any one of the preceding Claims, **characterised in that** the receiving control circuit is set up to carry out the automatic radio receiving frequency search operation with continuously decreasing radio receiving search frequencies in each search cycle.

10. A radio transmission system according to any one of the preceding Claims, **characterised in that** the receiving control circuit is set up to determine the search operation starting frequency and the maximum search operation frequency range for the respective next radio receiving frequency search operation depending on the time interval from the last successful reception of a radio message to the expected reception of the next radio message from the relevant transmitter.

11. A radio transmission system according to any one of the preceding Claims, **characterised in that** the radio transmitter is an element of a measuring appliance, wherein it is set up to transmit measured data of the measuring appliance in radio messages to the radio receiver.

12. A radio system according to Claim 11, **characterised in that** the measuring appliance is a consumption measuring appliance, in particular an electronic heating cost distributor, water meter, gas meter, heat-quantity meter or supply meter.

13. A radio transmission system according to any one of the preceding Claims, **characterised in that** it is designed for unidirectional radio operation for digital data distribution from the respective radio transmitter to the radio receiver.

## Revendications

1. Système de transmission radioélectrique doté d'au moins un émetteur radioélectrique, qui comporte un circuit de commande d'émission et qui est agencé pour émettre, d'après un certain schéma de temps d'émission des radiotélégrammes ayant chacun une partie données utiles et une partie en-tête précédant la partie données utiles et comportant une certaine structure de modulation, et doté d'au moins d'un récepteur radioélectrique contenant un circuit de commande de réception et destiné à recevoir des radiotélégrammes de l'émetteur radioélectrique, le récepteur radioélectrique étant agencé pour exécuter, dans un mode opérationnel Recherche commandé par le circuit de commande de réception, une recherche automatique de fréquence de réception radioélectrique afin d'accorder la fréquence de réception radioélectrique du récepteur radioélectrique sur la fréquence d'émission radioélectrique de l'émetteur radioélectrique ; lors de la recherche de fréquence de réception radioélectrique, le récepteur radioélectrique explorant cycliquement une plage donnée de tolérance de fréquence lorsqu'il reçoit un signal radioélectrique avec une structure de modulation correspondant à celle de la partie en-tête des radiotélégrammes de l'émetteur radioélectrique, **caractérisé en ce que** la durée de la partie en-tête des radiotélégrammes est plus longue que la durée d'un cycle de recherche de fréquence de réception radioélectrique.

2. Système de transmission radioélectrique selon la revendication 1, **caractérisé en ce que** le circuit de commande de réception du récepteur radioélectrique comporte des moyens pour détecter l'intensité de champ de réception en cas de réception de signaux radioélectriques électriques et est agencé, en vue de la réception de la partie données utiles d'un radiotélégramme respectif, pour sélectionner la fréquence de réception à laquelle le circuit de commande de réception a détecté l'intensité de champ de réception maximale lors de la détection de l'en-tête au cours du cycle de recherche de fréquence de réception radioélectrique.

3. Système de transmission radioélectrique selon la revendication 1, **caractérisé en ce que** les radiotélégrammes sont des signaux radioélectriques modulés en fréquence ou des signaux radioélectriques modulés en phase.

4. Système de transmission radioélectrique selon la revendication 1 ou 2, **caractérisé en ce que** la partie en-tête des radiotélégrammes de l'émetteur radioélectrique contient une structure de modulation ayant une séquence de données binaires de 0-1-0-1-...

5. Système de transmission radioélectrique selon l'une quelconque des revendications précédentes, **caractérisé en ce que** le circuit de commande de réception du récepteur radioélectrique est agencé pour réaliser, lors d'un cycle de recherche de fréquence de réception radioélectrique, les réglages de fréquence de réception les uns après les autres en fonction d'une probabilité décroissante d'une réception d'un radiotélégramme par l'émetteur concerné.

6. Système de transmission radioélectrique selon l'une quelconque des revendications précédentes, **caractérisé en ce que** le circuit de commande de réception du récepteur radioélectrique est agencé, lors d'un cycle de recherche de fréquence de réception radioélectrique pour la réception d'un radiotélégramme attendu d'un émetteur radioélectrique, pour sélectionner d'abord les réglages de fréquence de réception pour lesquels un précédent radiotélégramme de cet émetteur radioélectrique a été reçu.

7. Système de transmission radioélectrique selon l'une quelconque des revendications précédentes, **caractérisé en ce que** l'émetteur radioélectrique est agencé pour émettre ses radiotélégrammes à des intervalles conformément au schéma de temps d'émission durant des intervalles de temps d'émission courts, et **en ce que** le circuit de commande de réception du récepteur radioélectrique est agencé pour commuter, conformément au schéma de temps d'émission, le récepteur radioélectrique en mode prêt à recevoir pour la durée des intervalles de temps respectifs de disponibilité de réception afin de recevoir des radiotélégrammes de l'émetteur radioélectrique, la recherche respective de fréquence de réception radioélectrique étant démarrée au début de chaque intervalle de temps de disponibilité de réception.

8. Système de transmission radioélectrique selon l'une quelconque des revendications précédentes, **caractérisé en ce que** le circuit de commande de réception du récepteur radioélectrique est agencé pour effectuer la recherche de fréquence de réception radioélectrique avec une largeur de bande de recherche qui se différencie de la largeur de bande de réception radioélectrique destinée à la réception des données utiles, qui est en particulier plus grande que la largeur de bande de réception radioélectrique destinée à la réception des données utiles.

9. Système de transmission radioélectrique selon l'une quelconque des revendications précédentes, **caractérisé en ce que** le circuit de commande de réception est agencé pour exécuter la recherche automatique de fréquence de réception radioélectrique en diminuant continuellement la fréquence de recherche de réception radioélectrique à chaque cycle de recherche.

10. Système de transmission radioélectrique selon l'une quelconque des revendications précédentes, **caractérisé en ce que** le circuit de commande de réception est agencé pour définir la fréquence initiale de recherche et la plage maximale de fréquences de recherche pour chaque prochaine recherche de fréquence de réception radioélectrique en fonction de l'écart temporel entre la dernière réception réussie d'un radiotélégramme et la réception attendue du prochain radiotélégramme par l'émetteur concerné.

11. Système de transmission radioélectrique selon l'une quelconque des revendications précédentes, **caractérisé en ce que** l'émetteur radioélectrique est un élément d'un appareil de mesure, ledit émetteur radioélectrique étant agencé pour envoyer au récepteur radioélectrique des données de mesure de l'appareil de mesure dans des radiotélégrammes.

12. Système de radiocommunication selon la revendication 11, **caractérisé en ce que** l'appareil de mesure est un appareil de mesure de consommation, en particulier un répartiteur de coûts de chauffage, un compteur d'eau, un compteur de gaz, un compteur calorimétrique ou un compteur de courant électronique.

13. Système de transmission radioélectrique selon l'une quelconque des revendications précédentes, **caractérisé en ce qu'**il est agencé pour un fonctionnement radioélectrique unidirectionnel pour la transmission numérique de données de l'émetteur radioélectrique respectif au récepteur radioélectrique.
